Europäisches Patentamt

European Patent Office

Office européen des brevets

(11) Veröffentlichungsnummer: **0 345 365 B1**

(12) **EUROPÄISCHE PATENTSCHRIFT**

(45) Veröffentlichungstag der Patentschrift: **29.12.93**

(51) Int. Cl.⁵: **H03G 9/02**, H04N 5/60

(21) Anmeldenummer: **88109041.9**

(22) Anmeldetag: **07.06.88**

(54) **Digitale Deemphasisschaltung.**

(43) Veröffentlichungstag der Anmeldung:
**13.12.89 Patentblatt 89/50**

(45) Bekanntmachung des Hinweises auf die
Patenterteilung:
**29.12.93 Patentblatt 93/52**

(84) Benannte Vertragsstaaten:
**DE FR GB IT NL**

(56) Entgegenhaltungen:
**GB-A- 2 134 357**
**GB-A- 2 196 519**

**IEEE TRANSACTIONS ON CONSUMER ELEC-
TRONICS, Band CE-32, Nr. 3, August 1986,
Seiten 453-461, IEEE, New York, US; Z. RAZ et
al.: "A digital signal processing approach to
multichannel television sound decoding"**

**J. AUDIO ENG. SOC., Band 34, Nr. 9, September 1986, Seiten 647-660, J. JAMES GIBSON:
"Effects of receiver design and transmission
impairments on audio signal quality in the
BTSC system for multichannel television
sound"**

**IEEE TRANSACTIONS ON CONSUMER ELEC-
TRONICS, 1984, Seiten 633-640; L.B. TYLER et**

**al.: "A companding system for multichannel
TV sound"**

**JOURNAL OF THE AUDIO ENGINEERING SO-
CIETY, Band 32, Nr. 5, Mai 1984, Seiten
316-327, New York, US; G.W. McNALLY:
"Dynamic range control of digital audio signals"**

(73) Patentinhaber: **Deutsche ITT Industries GmbH
Hans-Bunte-Strasse 19
D-79108 Freiburg(DE)**

(72) Erfinder: **Reich, Werner, Dr. Ing.
Kleiststrasse 2a
D-7830 Emmendingen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Beschreibung

Die Erfindung beschäftigt sich mit der Schaffung einer digitalen Deemphasisschaltung für dynamickomprimierte, im Zweierkomplement-Dualsystem digitalisierte, amplitudennormierte Audiosignale, welche Schaltung im Audioteil eines Fernsehempfängers realisiert werden kann, der zum Empfang des US-amerikanischen BTSC-Mehrkanal-Fernseh-Standards vorgesehen ist. Das System dieses Standards ist in der Zeitschrift "IEEE Transactions on Consumer Electronics", 1984, Seiten 633 bis 640 ausführlich beschrieben, wobei die einzelnen Teilschaltungen als Analogsignale verarbeitende Schaltungen erläutert sind.

Für die Erfindung sind insbesondere die Fig. 5 bis 15 auf den Seiten 636 bis 639 in Verbindung mit dem dortigen Beschreibungstext von Interesse. Die Umsetzung der vorbeschriebenen Analogschaltungen in entsprechende Digitalschaltungen, die von einem Analog/Digital-Wandler digitalisierte Signale verarbeiten sollen, ist, wie bei anderen Schaltungen nicht ohne weiteres möglich, da sich bei diesem direkten Ersatz von Analogschaltungen durch entsprechende Digitalschaltungen im vorliegenden Fall eine Regelschleife ohne Verzögerung ergeben würde, die digital nicht realisiert werden kann.

In "IEEE Transactions on Consumer Electronics", Band CE-32, Nr.3, August 1986, Seiten 453 bis 461, IEEE, New York, US ist von den Autoren Z. Raz et al unter dem Titel "A Digital Signal Processing Approach To Multichannel Television Sound Decoding" unter anderem eine digitale Deemphasisschaltung im Stereo-Summenkanal L + R erwähnt, deren Innenschaltung jedoch nicht näher beschrieben ist. Die digitale Deemphasisschaltung ist dabei Teil eines im HCMOS-Technik monolithisch integrierten Signalprozessors, der für die verschiedenen TV-Tonkanalstandards entwickelt wurde.

Die Aufgabe der in den Ansprüchen gekennzeichneten Erfindung besteht daher darin, eine verbesserte digitale Deemphasisschaltung für den BTSC-Mehrkanal-Fernseh-Standard anzugeben, bei der insbesondere eine rasche Konvergenz des digitalen Ausgangssignals erreicht wird.

Die Deemphasisschaltung nach der Erfindung, wie sie in den Ansprüchen 1 und 2 angegeben ist, läßt sich ohne weiteres in Form integrierter Halbleiterschaltungen realisieren und insbesondere in den heute bereits üblichen sogenannten digitalen Fernsehempfängern mit Vorteil einsetzen.

Die Erfindung wird nun anhand der Figuren der Zeichnung näher erläutert.

Fig. 1 zeigt stark schematisiert das Blockschaltbild einer ersten Ausführungsvariante der Erfindung, und

Fig. 2 zeigt zwei Kurven zur Erläuterung der Funktionsweise einer Teilschaltung von Fig. 1, und

Fig. 3 zeigt ebenfalls stark schematisiert das Schaltbild einer zweiten Ausführungsvariante der Erfindung.

In den Figuren der Zeichnung wird vorausgesetzt, daß das digitale Audiosignal ss aus dem empfangenen Fernsehsendersignal abgetrennt und mittels eines üblichen Analog/Digital-Wandlers derart digitalisiert ist, daß Signale im Zweierkomplement-Dualsystem vorliegen, und daß diese Signale derart amplitudennormiert sind, daß sie lediglich im digitalen Zahlenbereich zwischen größer/gleich -1 und kleiner +1 liegen. (Die Bereichsgrenze "gleich +1" fehlt bewußt, da bekanntlich im Zweierkomplement-Dualsystem bei linksbündiger Darstellung wie im vorliegenden Fall die positive Eins fehlt.)

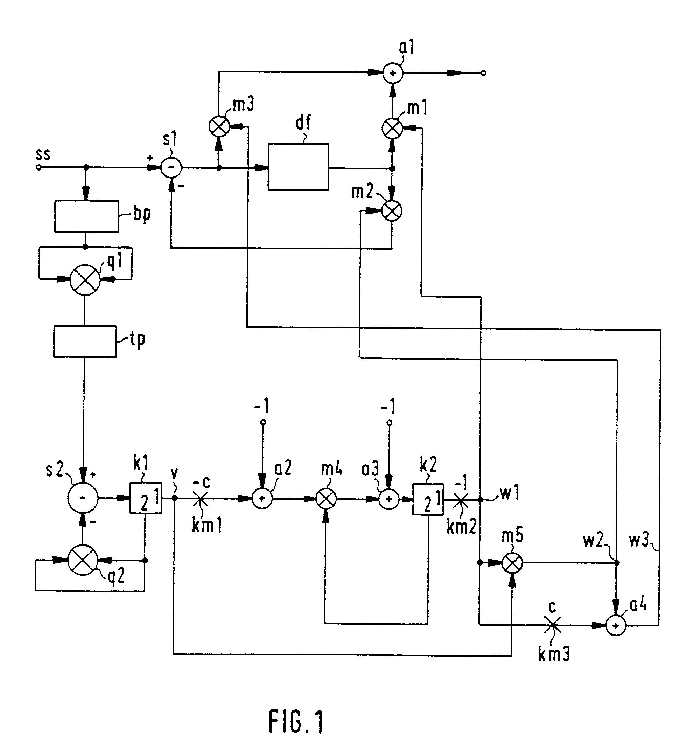

In Fig. 1 ist das Audiosignal ss dem Minuend-Eingang des ersten Subtrahierers s1 zugeführt, von dessen Ausgang der Eingang des Digitalfilters df angesteuert ist. Dieses hat die Übertragungsfunktion $F(z) = (b-ac)/(z+a)$. Dabei ist $z$, wie bei der mathematischen Behandlung von Digitalfiltern üblich, die komplexe Frequenzvariable, und a, b, c sind Konstanten, die dessen Frequenzgang derart bestimmen, daß sich die BSTC-Standard-gerechte Deemphasisfunktion ergibt. Bevorzugte dezimale Zahlenwerte für die drei Konstanten sind: a = -118/128, b = 2/128, c = 8/128.

Der Ausgang des Digitalfilters df ist mit jeweils einem Eingang des ersten und des zweiten Multiplizierers m1, m2 verbunden. Der Ausgang des ersten Multiplizierers m1 liegt am einen Eingang des ersten Addierers a1 und der des zweiten Multiplizieres m2 am Subtrahend-Eingang des ersten Subtrahierers s1. Dessen Ausgang liegt am einen Eingang des dritten Multiplizierers m3, dessen Ausgang mit dem anderen Eingang des ersten Addierers a1 verbunden ist. An dessen Ausgang ist das Ausgangssignal der Deemphassisschaltung abzunehmen.

Das Audiosignal ss ist ferner dem Eingang des Bandpasses bp zugeführt, der das ohne Schwierigkeiten zu realisierende Pendant zum entsprechenden analogen Bandpaß der eingangs genannten Literaturstelle, S. 637, Text der linken Spalte in Verbindung mit Fig. 9 und 10 ist und der praktisch die gleiche Übertragungsfunktion wie letzterer hat. Der Ausgang des Bandpasses bp speist den ersten Quadrierer q1, dessen Ausgang über den Tiefpaß tp, dessen Grenzfrequenz in der Größenordnung von 10 Hz liegt, den Minuendeingang des zweiten Subtrahierers s2 speist.

Der Ausgang des zweiten Subtrahierers s2 liegt am Eingang des begrenzenden ersten Akkumulators k1. Dieser ist so aufgebaut, daß die in ihm enthaltene Addierschaltung bei Erreichen der beiden oben erwähnten Zahlenbereichgrenzen oder bei Addierergebnissen, die diese Grenzen überschreiten, lediglich ein der jeweiligen Grenze entsprechendes Signal abgibt. In einem Dezimalzahlenbeispiel ausgedrückt begrenzt die Addierschaltung also z.B. bei einem Addierergebnis -2 auf -1 oder bei einem Ergebnis +1,5 auf die von der Stellenzahl des Audiosignals her mögliche nächstniedere Zahl als +1.

Der Akkumulator k1 enthält wie üblich außer der erwähnten Addierschaltung noch einen Zwischenspeicher, also z.B. ein Register oder ähnliches, über das, um eine Periodendauer des die Digitalsignalverarbeitung taktenden Taktsystems verzögert, das Ausgangssignal der Addierschaltung an deren einen Eingang zurückgekoppelt wird. Bei der Erfindung hat nun der Akkumulator k1 ebenso wie der weiter unten noch näher zu erläuternde zweite Akkumulator k2 den ersten und den zweiten Ausgang 1, 2, wobei der erste der Ausgang der Addierschaltung und der zweite der Ausgang des Zwischenspeichers ist. Letzterer liegt am Eingang des Quadrierers q, dessen Ausgang mit dem Subtrahend-Eingang des zweiten Subtrahierers s2 verbunden ist.

Die Teilschaltung s2, k1, q2 stellt einen überraschend einfachen Radizierer dar, der aus seinem Eingangssignal die Quadraturwurzel bildet. Beim Quadrierer q2 ist die Tatsache, daß das Quadrat der negativsten Zahl -1 zweierkomplementsystembedingt nicht +1, sondern wiederum -1 ergibt, gerade bewußt ausgenutzt. (Bei linksbündigen Zweierkomplementzahlen ist nämlich die erste Null mit der Vorkomma-Null eines Dezimalbruchs vergleichbar und zugleich Vorzeichenstelle, während eine Eins in dieser Stelle das negative Vorzeichen angibt, jedoch nicht mit der Vorkomma-Eins eines Dezimalbruchs vergleichbar ist.)

Die insgesamt als Radizierer wirkende Teilschaltung s2, k1, q2 vergleicht den quadrierten Ausgangswert des Akkumulators k1 mit dem Eingangswert des Audiosignals ss im Subtrahierer s2, so daß sich am Ausgang des Akkumulators k1 nach einigen Abtastschritten der der Quadratwurzel entsprechende Wert des Ausgangssignals des Tiefpasses tp einstellt.

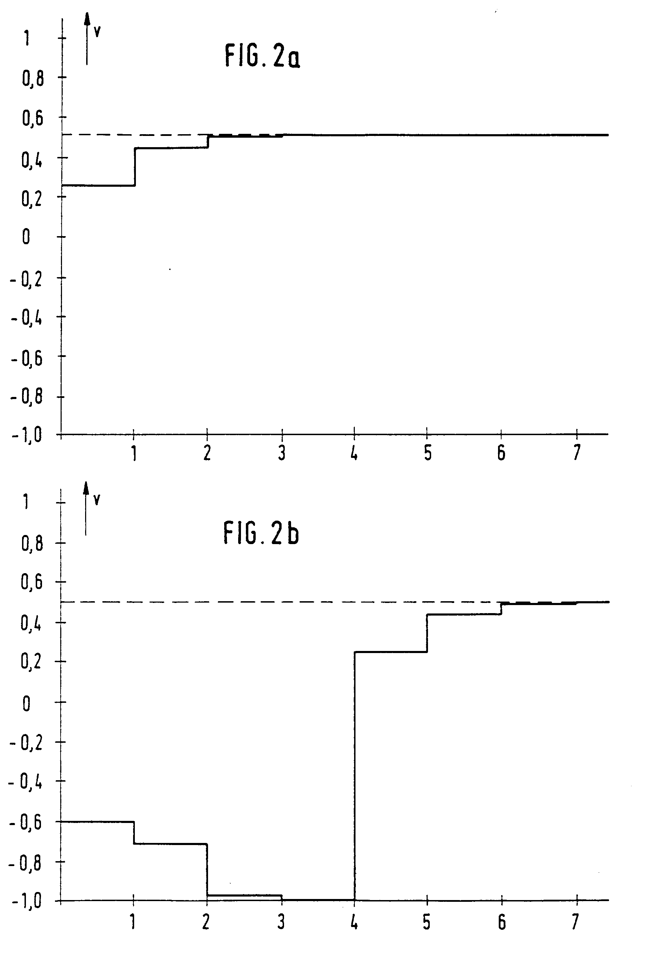

Für zwei verschiedene Anfangsbedingungen ist dies in Fig. 2 gezeigt, deren Ordinaten des besseren Verständnisses wegen mit Dezimalwerten zwischen +1 und -1 bezeichnet sind und auf deren Abszissen einige von 0 bis 7 numerierte Abtastzeitpunkte des erwähnten Taktsystems markiert sind.

Die Fig. 2a betrifft den Fall, daß das Tiefpaßausgangssignal während der acht Abtastzeitpunkte den Wert $0,25 = 2^{-2}$ und daß das Ausgangssignal v am ersten Ausgang 1 des Akkumulators k1, also an dem von dessen Addierschaltung, den Anfangswert 0 aufweist. Wie die Fig. 2a zeigt, konvergiert die Schaltung bereits zum Abtastzeitpunkt Nr. 2 ausreichend genau gegen die Quadratwurzel aus 0,25, nämlich 0,5.

Die Fig. 2b setzt wieder den Wert des Tiefpaßausgangssignals gleich 0,25 als konstant über die acht Abtastzeitpunkte voraus, während jedoch für v der Anfangswert -0,6 angenommen ist. Fig. 2b zeigt, daß der Radizierer auch in diesem Fall zum beabsichtigten Wert 0,5 konvergiert. Dabei ist interessant, daß die Teilschaltung s2, k1, q2 zunächst in den Abtastzeitpunkten Nr. 1 bis 3 zu immer negativeren Zahlen läuft, und erst nachdem -1 erreicht ist, von selbst in den positiven Zahlenbereich "springt", um von dort aus monoton gegen den Zielwert 0,5 zu konvergieren.

Da die Frequenz des Taktsystems weit höher als die vom Abtasttheorem geforderte Frequenz liegt, ist es ohne weiteres zulässig, eine "Einschwingzeit" von mehreren Abtastperioden zuzulassen.

Das Signal v am ersten Ausgang des ersten Akkumulators k1, das, wie bereits erwähnt wurde, den Effektivwert darstellt, ist dem Eingang des ersten Konstantenmultiplizierers km1 zugeführt, der mit der Konstanten -c multipliziert und dessen Ausgang am einen Eingang des zweiten Addierers a2 liegt. Dessen Ausgang ist mit dem einen Eingang des vierten Multiplizieres m4 verbunden, dessen Ausgang am einen Eingang des dritten Addierers a3 liegt. Dem jeweils anderen Eingang der beiden Addierer a2, a3 ist ein Signal für die konstante Zahl -1 zugeführt.

Der Ausgang des dritten Addierers a3 liegt am Eingang des zweiten Akkumulators k2, der vorzugsweise ein begrenzender ist. Sein Ausgang liegt am Eingang des zweiten Konstantenmultiplizierers km2 , der mit -1 multipliziert und dessen Ausgangssignal dem anderen Eingang des ersten Multiplizierers m1, dem einen Eingang des fünften Multiplizierers m5 und dem Eingang des dritten Konstantenmultiplizierers km3 zugeführt ist, der mit der Konstanten c multipliziert. Am einen Eingang des vierten Addierers a4 liegt der Ausgang des fünften Multiplizierers m5, am anderen Eingang der Ausgang des dritten Konstantenmultipliziers km3 und am Ausgang der andere Eingang des dritten Multipliziers m3. Schließlich ist der Ausgang des fünften Multiplizierers m5 am anderen Eingang des zweiten Multiplizierers m2 angeschlossen.

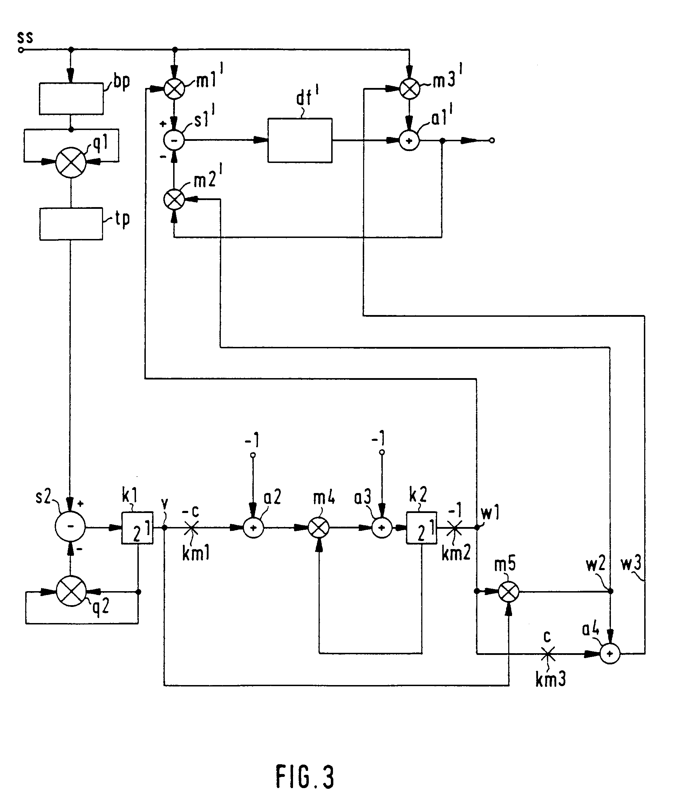

Bei der zweiten Ausführungsvariante der Erfindung nach Fig. 3 ist der untere Figurenteil mit dem unteren Figurenteil der Fig. 1 identisch; lediglich der obere Figurenteil mit den durch den Apostroph jeweils gekennzeichneten Bezugszeichen weicht von dem oberen Figurenteil der Fig. 1 ab. Die Abweichung besteht in der anderen Anordnung und der anderen gegenseitigen Verbindung der drei Multiplizierer m1', m2', m3', des Subtrahierers s1', des Addierers a1' und des Digitalfilters df', während die Ansteuerung vom unteren Figurenteil aus die gleiche ist wie in Fig. 1.

Im einzelnen ist das Audiosignal ss dem einen Eingang des ersten Multiplizierers m1' und dem einen Eingang des dritten Multiplizierers m3' zugeführt. Am Ausgang des ersten Multiplizierers m1' liegt der Minuend-Eingang des Subtrahierers s1', dessen Ausgang mit dem Eingang des Digitalfilters df' verbunden ist, das dieselbe Übertragungsfunktion wie das Digitalfilter df nach Fig. 1 hat. Sein Ausgang liegt am einen Eingang des Addierers a1', dessen Ausgang wiederum der Ausgang der Deemphasisschaltung ist und dessen anderer Eingang mit dem Ausgang des dritten Multiplizierers m3' verbunden ist.

Der Subtrahend-Eingang des Subtrahierers s1' liegt am Ausgang des zweiten Multiplizierers m2', dessen einer Eingang am Ausgang des ersten Addierers a1' und dessen anderer Eingang am Ausgang des fünften Multiplizierers m5 liegt. Der jeweils andere Eingang des ersten bzw. dritten Multiplizierers m1', m3' liegt am Ausgang des zweiten Konstantenmultiplizierers km2 bzw. des vierten Addierers a4.

Bei den beiden Varianten der Erfindung gelingt die eingangs erwähnte Umsetzung der Analogschaltung in die beabsichtigte Digitalschaltung im wesentlichen dadurch, daß das Signal v, das dem analogen Effektivwertsteuersignal entspricht, mittels der hinter dem ersten Akkumulator k1 liegenden Teilschaltung in die drei Signale w1, w2, w3 umgeformt wird, die den drei Multiplizierern m1, m1'; m2, m2'; m3, m3' zugeführt werden. Im einzelnen gilt dabei in sehr guter Näherung:

$$w1 = 1/(1+cv);$$
$$w2 = v/(1+cv) = vw1;$$
$$w3 = (c+v)/(1+cv) = cw1 + w2.$$

Für für die Bildung des Signals w1 wird eine mit dem oben geschilderten "Radizierer" vergleichbare Regelschleife m4, a3, k2 benutzt, die w1, falls zu klein, vergrößert und umgekehrt. Die Signale w1, w2, w3 sind somit nur von der Konstanten c und dem Signal v abhängig.

**Patentansprüche**

1. Digitale Deemphasisschaltung für ein dynamikkomprimiertes, im Zweierkomplement-Dualsystem digitalisiertes, amplitudennormiertes Audiosignal (ss) mit
   - einem ersten Subtrahierer (s1), dessen Minuend-Eingang das Audio-Signal (ss) zugeführt ist,

   - einem Digitalfilter (df), das die Übertragungsfunktion $F(z) = (b-ac)/(z+a)$ hat, wobei z die komplexe Frequenzvariable und a, b, c dessen Frequenzgang bestimmende Konstanten sind, und dessen Eingang am Ausgang des ersten Subtrahierers (s1) liegt,
   - einem ersten und einem zweiten Multiplizierer (m1, m2), deren jeweiliger einer Eingang am Ausgang des Digitalfilters (df) liegt,
   - einem dritten Multiplizierer (m3), dessen einer Eingang am Ausgang des ersten Subtrahierers (s1) angeschlossen ist,
   - einem ersten Addierer (a1), dessen einer Eingang am Ausgang des ersten Multiplizierers (m1) und dessen anderer Eingang am Ausgang des dritten Multiplizierers (m3) liegt sowie dessen Ausgang der Ausgang der Deemphasisschaltung ist,
   - einem Bandpaß (bp), dessen Eingang das Audiosignal zugeführt ist,
   - einem ersten Quadrierer (q1), dessen Eingang am Ausgang des Bandpasses (bp) liegt,
   - einem Tiefpaß (tp), dessen Eingang am Ausgang des ersten Quadrierers (q1) angeschlossen ist und dessen Grenzfrequenz in der Größenordnung von 10 Hz liegt,
   - einem zweiten Subtrahierer (s2), dessen Minuendeingang am Ausgang des Tiefpasses (tp) liegt,
   - einem begrenzenden ersten Akkumulator (k1), dessen Eingang am Ausgang des zweiten Subtrahierers (s2) liegt,
   - einem zweiten Quadrierer (q2), dessen Eingang am zweiten Ausgang (2) des ersten Akkumulators (k1) und dessen Ausgang am Subtrahend-Eingang des zweiten Subtrahierers (s2) liegt,
   - einem ersten Konstantenmultiplizierer (km1), dem das erste Ausgangssignal (v) des ersten Akkumulators (k1) und die Konstante -c zugeführt sind,
   - einem zweiten Addierer (a2), dessen einem Eingang das Ausgangssignal des ersten Konstantenmultiplizierers (km1) und dessen anderem Eingang ein Signal für die Zahl -1 zugeführt sind,
   - einem vierten Multiplizierer (m4), dessen einer Eingang am Ausgang des zweiten Addierers (a2) liegt,
   - einem dritten Addierer (a3), dessen einem Eingang das Ausgangssignal des vierten Multiplizierers (m4) und dessen anderem Eingang das Signal für die Zahl -1 zugeführt sind,

- einem zweiten Akkumulator (k2), dessen Eingang am Ausgang des dritten Addierers (a3) liegt und dessen zweiter Ausgang (2) am anderen Eingang des vierten Multiplizierers (m4) liegt,
- einem zweiten Konstantenmultiplizierer (km2), dem ein Signal für die Zahl -1 und das erste Ausgangssignal des zweiten Akkumulators (k2) zugeführt sind und dessen Ausgangssignal dem anderen Eingang des ersten Multiplizierers (m1) zugeführt ist,
- einem fünften Multiplizierer (m5), dessen einer bzw. anderer Eingang am ersten Ausgang des ersten Akkumulators (k1) bzw. am Ausgang des zweiten Konstantenmultiplizierers (km2) und dessen Ausgang am anderen Eingang des zweiten Multiplizierers (m2) liegt, dessen Ausgangssignal dem Subtrahend-Eingang des ersten Subtrahierers (s1) zugeführt ist,
- einem dritten Konstantenmultiplizierer (km3), dem das Ausgangssignal des zweiten Konstantenmultiplizierers (km2) und die Konstante c zugeführt sind, und
- einem vierten Addierer (a4), dessen einer Eingang am Ausgang des fünften Multiplizierers (m5) und dessen anderer Eingang am Ausgang des dritten Konstantenmultiplizierers (km3) sowie dessen Ausgang am anderen Eingang des dritten Multiplizierers (m3) liegt.

2. Digitale Deemphasisschaltung für ein dynamikkomprimiertes, im Zweierkomplement-Dualsystem digitalisiertes, amplitudennormiertes Audiosignal (ss) mit
- einem ersten Multiplizierer (m1′), dessen einem Eingang das Audiosignal (ss) zugeführt ist,
- einem ersten Subtrahierer (s1′), dessen Minuend-Eingang am Ausgang des ersten Multiplizierers (m1′) liegt,
- einem Digitalfilter (df′), das die Übertragungsfunktion $F(z) = (b-ac)/(z+a)$ hat, wobei z die komplexe Frequenzvariable und a, b, c dessen Frequenzgang bestimmende Konstanten sind, und dessen Eingang am Ausgang des ersten Subtrahierers (s1′) liegt,
- einem ersten Addierer (a1′), dessen einer Eingang am Ausgang des Digitalfilters (df′) liegt und dessen Ausgang der Ausgang der Deemphasisschaltung ist,
- einem zweiten Multiplizierer (m2′), dessen einer Eingang am Ausgang des ersten Addierers (a1′) liegt,

- einem dritten Multiplizierer (m3′), dessen einem Eingang das Audiosignal (ss) zugeführt ist und dessen Ausgang am anderen Eingang des ersten Addierers (a1′) liegt,
- einem Bandpaß (bp), dessen Eingang das Audiosignal zugeführt ist,
- einem ersten Quadrierer (q1), dessen Eingang am Ausgang des Bandpasses (bp) liegt,
- einem Tiefpaß (tp), dessen Eingang am Ausgang des ersten Quadrierers (q1) angeschlossen ist und dessen Grenzfrequenz in der Größenordnung von 10 Hz liegt,
- einem zweiten Subtrahierer (s2), dessen Minuendeingang am Ausgang des Tiefpasses (tp) liegt,
- einem begrenzenden ersten Akkumulator (k1), dessen Eingang am Ausgang des zweiten Subtrahierers (s2) liegt,
- einem zweiten Quadrierer (q2), dessen Eingang am zweiten Ausgang des ersten Akkumulators (k1) und dessen Ausgang am Subtrahend-Eingang des zweiten Subtrahierers (s2) liegt,
- einem ersten Konstantenmultiplizierer (km1), dem das erste Ausgangssignal des ersten Akkumulators (k1) und die Konstante -c zugeführt sind,
- einem zweiten Addierer (a2), dessen einem Eingang das Ausgangssignal des ersten Konstantenmultiplizierers (km1) und dessen anderem Eingang ein Signal für die Zahl -1 zugeführt sind,
- einem vierten Multiplizierer (m4), dessen einer Eingang am Ausgang des zweiten Addierers (a2) liegt,
- einem dritten Addierer (a3), dessen einem Eingang das Ausgangssignal des vierten Multiplizierers (m4) und dessen anderem Eingang das Signal für die Zahl -1 zugeführt sind,
- einem zweiten Akkumulator (k2), dessen Eingang am Ausgang des dritten Addierers (a3) liegt und dessen zweiter Ausgang (2) mit dem anderen Eingang des vierten Multiplizierers (m4) verbunden ist,
- einem zweiten Konstantenmultiplizierer (km2), dem ein Signal für die Zahl -1 und das erste Ausgangssignal des zweiten Akkumulators (k2) zugeführt sind und dessen Ausgangssignal dem anderen Eingang des ersten Multiplizierers (m1′) zugeführt ist,
- einem fünften Multiplizierer (m5), dessen einer bzw. anderer Eingang am ersten Ausgang des ersten Akkumulators (k1) bzw. am Ausgang des zweiten Konstantenmultiplizierers (km2) und dessen Ausgang am anderen Eingang des zweiten Multiplizierers (m2′) liegt, dessen Ausgangssignal dem Subtrahend-Eingang des ersten Subtrahierers (s1') zugeführt ist,

- einem dritten Konstantenmultiplizierer (km3), dem das Ausgangssignal des zweiten Konstantenmultiplizierers (km2) und die Konstante c zugeführt sind, und
- einem vierten Addierer (a4), dessen einer Eingang am Ausgang des fünften Multiplizierers (m5) und dessen anderer Eingang am Ausgang des dritten Konstantenmultiplizierers (km3) sowie dessen Ausgang am anderen Eingang des dritten Multiplizierers (m3′) liegt.

## Claims

1. Digital deemphasis circuit for a volume-compressed, amplitude-normalized audio signal (ss) digitized in the two's complement binary system, comprising
   - a first subtracter (s1) whose minuend input is fed with the audio signal (ss),
   - a digital filter (df) having the transfer function $F(z) = (b-ac)/(z + a)$, where $z$ is the complex frequency variable, and a, b, c are constants determining the frequency response of the digital filter (df), and having its input connected to the output of the first subtracter (s1),
   - a first multiplier (m1) and a second multiplier (m2) each having one input connected to the output of the digital filter (df),
   - a third multiplier (m3) having one input connected to the output of the first subtracter (s1),
   - a first adder (a1) one input of which is connected to the output of the first multiplier (m1) and the other input of which is connected to the output of the third multiplier (m3), and the output of which is the output of the deemphasis circuit,
   - a band-pass filter (bp) whose input is fed with the audio signal,
   - a first squarer (q1) having its input connected to the output of the band-pass filter (bp),
   - a low-pass filter (tp) having its input connected to the output of the first squarer (q1) and having a cut-off frequency on the order of 10 Hz,
   - a second subtracter (s2) having its minuend input connected to the output of the low-pass filter (tp),
   - a limiting first accumulator (k1) having its input connected to the output of the second subtracter (s2),
   - a second squarer (q2) having its input connected to a second output (2) of the first accumulator (k1) and having its output coupled to the subtrahend input of the second subtracter (s2),
   - a first constant multiplier (km1) fed with a first output signal (v) from the first accumulator (k1) and with the constant -c,
   - a second adder (a2) one input of which is fed with the output signal from the first constant multiplier (km1), and the other input of which is fed with a signal for the number -1,
   - a fourth multiplier (m4) having one input connected to the output of the second adder (a2),
   - a third adder (a3) one input of which is fed with the output signal from the fourth multiplier (m4), and the other input of which is fed with the signal for the number -1,
   - a second accumulator (k2) having its input connected to the output of the third adder (a3) and having its second output (2) coupled to the other input of the fourth multiplier (m4),
   - a second constant multiplier (km2) which is fed with a signal for the number -1 and with the first output signal from the second accumulator (k2) and whose output signal is fed to the other input of the first multiplier (m1),
   - a fifth multiplier (m5) one input of which is connected to the first output of the first accumulator (k1) and the other input of which is connected to the output of the second constant multiplier (km2), and the output of which is coupled to the other input of the second multiplier (m2), whose output signal is fed to the subtrahend input of the first subtracter (s1),
   - a third constant multiplier (km3) fed with the output signal from the second constant multiplier (km2) and with the constant c, and
   - a fourth adder (a4) one input of which is connected to the output of the fifth multiplier (m5) and the other input of which is connected to the output of the third constant multiplier (km3), and the output of which is coupled to the other input of the third multiplier (m3).

2. Digital deemphasis circuit for a volume-compressed, amplitude-normalized audio signal (ss) digitized in the two's complement binary system, comprising

- a first multiplier (m1') one input of which is fed with the audio signal (ss),
- a first subtracter (s1') having its minuend input connected to the output of the first multiplier (m1'),
- a digital filter (df') having the transfer function $F(z) = (b\text{-}ac)/(z + a)$, where $z$ is the complex frequency variable, and a, b, c are constants determining the frequency response of the digital filter (df'), and having its input connected to the output of the first subtracter (s1'),
- a first adder (a1') one input of which is coupled to the output of the digital filter (df'), and the output of which is the output of the deemphasis circuit,
- a second multiplier (m2') having one input connected to the output of the first adder (a1'),
- a third multiplier (m3') one input of which is fed with the audio signal (ss), and the output of which is connected to the other input of the first adder (a1'),
- a band-pass filter (bp) whose input is fed with the audio signal,
- a first squarer (q1) having its input connected to the output of the band-pass filter (bp),
- a low-pass filter (tp) having its input connected to the output of the first squarer (q1) and having a cut-off frequency on the order of 10 Hz,
- a second subtracter (s2) having its minuend input connected to the output of the low-pass filter (tp),
- a limiting first accumulator (k1) having its input connected to the output of the second subtracter (tp),
- a second squarer (q2) having its input connected to a second output (2) of the first accumulator (k1) and having its output coupled to the subtrahend input of the second subtracter (s2),
- a first constant multiplier (km1) fed with a first output signal (v) from the first accumulator (k1) and with the constant -c,
- a second adder (a2) one input of which is fed with the output signal from the first constant multiplier (km1), and the other input of which is fed with a signal for the number -1,
- a fourth multiplier (m4) having one input connected to the output of the second adder (a2),

- a third adder (a3) one input of which is fed with the output signal from the fourth multiplier (m4), and the other input of which is fed with the signal for the number -1,
- a second accumulator (k2) having its input connected to the output of the third adder (a3) and having its second output (2) coupled to the other input of the fourth multiplier (m4),
- a second constant multiplier (km2) which is fed with a signal for the number -1 and with the first output signal from the second accumulator (k2) and whose output signal is fed to the other input of the first multiplier (m1'),
- a fifth multiplier (m5) one input of which is connected to the first output of the first accumulator (k1) and the other input of which is connected to the output of the second constant multiplier (km2), and the output of which is coupled to the other input of the second multiplier (m2'), whose output signal is fed to the subtrahend input of the first subtracter (s1'),
- a third constant multiplier (km3) fed with the output signal from the second constant multiplier (km2) and with the constant c, and
- a fourth adder (a4) one input of which is connected to the output of the fifth multiplier (m5) and the other input of which is connected to the output of the third constant multiplier (km3), and the output of which is coupled to the other input of the third multiplier (m3').

**Revendications**

1. Circuit de désaccentuation numérique pour un signal audio (ss), dont la dynamique est comprimée et dont l'amplitude est normalisée et qui est numérisé selon le système binaire de complémentation à deux, comprenant

- un premier soustracteur (s1), à l'entrée du diminuende duquel est envoyé le signal audio (ss),
- un filtre numérique (df), qui possède la fonction de transfert $F(z) = (b\text{-}ac)/(z + a)$, z étant la variable de fréquence complexe et a, b, c désignant des constantes déterminant la réponse en fréquence de ce filtre, et dont l'entrée est raccordée à la sortie du premier soustracteur (s1),
- des premier et second multiplicateurs (m1, m2), dont respectivement une entrée est raccordée à la sortie du filtre numérique (df),

- un troisième multiplicateur (m3), dont une entrée est raccordée à la sortie du premier soustracteur (s1),
- un premier additionneur (a1), dont une entrée est raccordée à la sortie du premier multiplicateur (m1) et dont l'autre entrée est raccordée à la sortie du troisième multiplicateur (m3), et dont la sortie constitue la sortie du circuit de désaccentuation,
- un filtre passe-bande (bp), à l'entrée duquel est envoyé le signal audio,
- un premier dispositif d'élévation au carré (q1), dont l'entrée est raccordée à la sortie du filtre passe-bande (bp),
- un filtre passe-bas (tp), dont l'entrée est raccordée à la sortie du premier dispositif d'élévation au carré (q1) et dont la fréquence limite est de l'ordre de 10 Hz,
- un second soustracteur (s2), dont l'entrée du diminuende est raccordée à la sortie du filtre passe-bas (tp),
- un premier accumulateur limiteur (k1), dont l'entrée est raccordée à la sortie du second soustracteur (s2),
- un second dispositif d'élévation au carré (q2), dont l'entrée est raccordée à la seconde sortie (2) du premier accumulateur (k1) et dont la sortie est connectée à l'entrée du nombre à soustraire du second soustracteur (s2),
- un premier multiplicateur (km1) réalisant la multiplication par une constante et auquel sont envoyés le premier signal de sortie (v) du premier accumulateur (k1) et la constante -c,
- un second additionneur (a2), à une entrée duquel est envoyé le signal de sortie du premier multiplicateur (km1) réalisant la multiplication par une constante et à la seconde entrée duquel est envoyé un signal pour le nombre -1,
- un quatrième multiplicateur (m4), dont une entrée est raccordée à la sortie du second additionneur (a2),
- un troisième additionneur (a3), à une entrée duquel est envoyé le signal de sortie du quatrième multiplicateur (m4) et à l'autre entrée duquel est envoyé le signal pour le nombre -1,
- un second accumulateur (k2), dont l'entrée est raccordée à la sortie du troisième additionneur (a3) et dont la seconde sortie (2) est raccordée à l'autre entrée du quatrième multiplicateur (m4),
- un second multiplicateur (km2) réalisant la multiplication par une constante et auquel sont envoyés un signal pour le nombre -1 et le premier signal de sortie du second accumulateur (k2) et dont le signal de sortie est envoyé à l'autre entrée du premier multiplicateur (m1),
- un cinquième multiplicateur (m5), dont l'une ou l'autre des entrées est raccordée à la première sortie du premier accumulateur (k1) ou à la sortie du second multiplicateur (km2) réalisant la multiplication par une constante et dont la sortie est raccordée à l'autre entrée du second multiplicateur (m2), dont le signal de sortie est envoyé à l'entrée du nombre à soustraire du premier soustracteur (s1),
- un troisième multiplicateur (km3) réalisant la multiplication par une constante et auquel sont envoyés un signal de sortie du second multiplicateur (km2) réalisant la multiplication par une constante et la constante (c), et
- un quatrième additionneur (a4), dont une entrée est raccordée à la sortie du cinquième multiplicateur (m5) et dont l'autre entrée est raccordée à la sortie du troisième multiplicateur (km3) réalisant la multiplication par une constante et dont la sortie est raccordée à l'autre entrée du troisième multiplicateur (m3).

2. Circuit de désaccentuation numérique pour un signal audio (ss), dont la dynamique est comprimée et dont l'amplitude est normalisée et qui est numérisé selon le système binaire de complémentation à deux, comprenant
   - un premier multiplicateur (m1'), à une entrée duquel est envoyé le signal audio (ss),
   - un premier soustracteur (s1'), dont l'entrée du diminuende est raccordée à la sortie du premier multiplicateur (m1'),
   - un filtre numérique (df'), qui possède la fonction de transfert $F(z) = (b-ac)/(z + a)$, $z$ étant la variable de fréquence complexe et $a$, $b$, $c$ désignant des constantes déterminant la réponse en fréquence de ce filtre, et dont l'entrée est raccordée à la sortie du premier soustracteur (s1'),
   - un premier additionneur (a1'), dont une entrée est raccordée à la sortie du filtre numérique (df') et dont la sortie constitue la sortie du circuit de désaccentuation,
   - un second multiplicateur (m2'), dont une entrée est raccordée à la sortie du premier additionneur (a1'),
   - un troisième multiplicateur (m3'), à une entrée duquel est envoyé le signal audio (ss) et dont la sortie est raccordée à l'autre entrée du premier additionneur (a1'),

- un filtre passe-bande (bp), à une entrée duquel est envoyé le signal audio,
- un premier dispositif d'élévation au carré (q1), dont l'entrée est raccordée à la sortie du filtre passe-bande (bp),
- un filtre passe-bas (tp), dont l'entrée est raccordée à la sortie du premier dispositif d'élévation au carré (q1) et dont la fréquence limite est de l'ordre de 10 Hz,
- un second soustracteur (s2), dont l'entrée du diminuende est raccordée à la sortie du filtre passe-bas (tp),
- un premier accumulateur limiteur (k1), dont l'entrée est raccordée à la sortie du second soustracteur (s2),
- un second dispositif d'élévation au carré (q2), dont l'entrée est raccordée à la seconde sortie du premier accumulateur (k1) et dont la sortie est connectée à l'entrée du nombre à soustraire du second soustracteur (s2),
- un premier multiplicateur (km1) réalisant la multiplication par une constante et auquel sont envoyés le premier signal de sortie du premier accumulateur (k1) et la constante -c,
- un second additionneur (a2), à une entrée duquel est envoyé le signal de sortie du premier multiplicateur (km1) réalisant la multiplication par une constante et à la seconde entrée duquel est envoyé un signal pour le nombre -1,
- un quatrième multiplicateur (m4), dont une entrée est raccordée à la sortie du second additionneur (a2),
- un troisième additionneur (a3), à une entrée duquel est envoyé le signal de sortie du quatrième multiplicateur (m4) et à l'autre entrée duquel est envoyé le signal pour le nombre -1,
- un second accumulateur (k2), dont l'entrée est raccordée à la sortie du troisième additionneur (a3) et dont la seconde sortie (2) est raccordée à l'autre entrée du quatrième multiplicateur (m4),
- un second multiplicateur (km2) réalisant la multiplication par une constante et auquel sont envoyés un signal pour le nombre -1 et le premier signal de sortie du second accumulateur (k2) et dont le signal de sortie est envoyé à l'autre entrée du premier multiplicateur (m1'),
- un cinquième multiplicateur (m5), dont l'une ou l'autre des entrées est raccordée à la première sortie du premier multiplicateur (k1) ou à la sortie du second multiplicateur (km2) réalisant la multiplication par une constante et dont la sortie est raccordée à l'autre entrée du second multiplicateur (m2'), dont le signal de sortie est envoyé à l'entrée du nombre à soustraire du premier soustracteur (s1'),
- un troisième multiplicateur (km3) réalisant la multiplication par une constante et auquel sont envoyés le signal de sortie du second multiplicateur (km2) réalisant la multiplication par une constante et la constante c, et
- un quatrième additionneur (a4), dont une entrée est raccordée à la sortie du cinquième multiplicateur (m5) et dont l'autre entrée est raccordée à la sortie du troisième multiplicateur (km3) réalisant la multiplication par une constante et dont la sortie est raccordée à l'autre entrée du troisième multiplicateur (m3').

FIG.1

FIG.2a

FIG.2b

FIG.3